# EUROPÄISCHE PATENTSCHRIFT

(11) **EP 0 608 698 B1**
(45) Veröffentlichungstag und Bekanntmachung des Hinweises auf die Patenterteilung: **18.03.1998**
(21) Anmeldenummer: 94100319.6
(22) Anmeldetag: 12.01.1994
(51) Int. Cl.: G01R 19/155, G01R 31/04

(54) **Prüfgerät zum wahlweisen Anzeigen einer elektrischen Spannung oder des Stromdurchgangs durch einen elektrischen Leiter**
Testing apparatus for alternatively indicating electric voltage or current passage through an electric conductor
Appareil de test pour indiquer aux choix la tension électrique ou le passage de courant dans un conducteur électrique

(30) Priorität: 28.01.1993 DE 4302292
(43) Veröffentlichungstag der Anmeldung: 03.08.1994
(73) Patentinhaber: THEO BENNING ELEKTROTECHNIK UND ELEKTRONIK GMBH & CO. KG, D-46397 Bocholt (DE)
(72) Erfinder: Wessels, Josef, D-46399 Bocholt (DE); Saul, Wilhelm, D-46395 Bocholt (DE); Tebroke, Wolfgang, D-46414 Rhede (DE)
(74) Vertreter: Stenger, Watzke & Ring Patentanwälte

(56) Entgegenhaltungen:
- DE-A- 2 659 363

## Beschreibung

Die Erfindung betrifft ein Prüfgerät zum wahlweisen Anzeigen einer elektrischen Spannung oder des Stromdurchgangs durch einen elektrischen Leiter mit zwei über ein Kabel miteinander verbundenen, jeweils mit einer Prüfspitze versehenen Handgriffen, mit einer Meßschaltung sowie mindestens einem Anzeigeelement zur Erfassung und Anzeige des an den Prüfspitzen anliegenden Spannungswertes sowie mit einer Spannungsquelle zur Bereitstellung des für die Messung und Anzeige des Stromdurchgangs erforderlichen Stromes.

Ein Prüfgerät dieser Art ist aus der DE- 27 17 826 B1 bekannt. Das Prüfgerät ist als Kombigerät ausgebildet und kann wahlweise zwei für die tägliche Praxis des Elektrotechnikers wichtige Messungen durchführen. Zum einen lassen sich mit dem bekannten Gerät Spannungsprüfungen durchführen. Hierbei wird je nach Phase eine von zwei Leuchtdioden zum Aufleuchten angeregt. Bei Wechselspannung leuchten beide Leuchtdioden. Zum anderen lassen sich mit dem bekannten Prüfgerät Stromdurchgänge durch beliebige elektrische Leiter durchführen. Hierzu ist das Prüfgerät mit einer Batterie versehen, deren Strom nach Betätigung eines Tastschalters durch die zu prüfende Leitung gelegt wird.

Nachteilig bei diesem Prüfgerät ist, daß dieses nicht vollständig wartungsfrei arbeitet, da von Zeit zu Zeit und insbesondere bei Durchführung vieler Stromdurchgangsprüfungen die Leistungsfähigkeit der Batterie absinkt und diese durch eine frische Batterie ersetzt werden muß.

Der Erfindung liegt die **Aufgabe** zugrunde, ein universell einsetzbares Prüfgerät zum wahlweisen Anzeigen einer elektrischen Spannung oder des Stromdurchgangs durch einen elektrischen Leiter zu schaffen, welches über seine gesamte Lebensdauer vollkommen wartungsfrei betrieben werden kann.

Die **Lösung** dieser Aufgabe wird im Anspruch 1 angegeben.

Ein solches Prüfgerät arbeitet batterieunabhängig und kann daher über seine gesamte Lebensdauer vollkommen wartungsfrei betrieben werden. Der für die Überprüfung des Stromdurchganges erforderliche Meßstrom wird von einer integrierten Solarzelle erzeugt. Da der durch eine solche Solarzelle erzeugte Strom nur gering ist, wird als Anzeigeelement für den Stromdurchgang ein dieser Solarzelle vorzugsweise parallelgeschaltetes, nur einen geringen Betriebsstrom benötigendes LCD-Element verwendet.

Gemäß der Erfindung ist der Solarzelle ein Elektrolyt-Kondensator parallelgeschaltet. Dieser Kondensator wird bei normalem Lichteinfall von der Solarzelle aufgeladen, so daß die in ihm gespeicherte elektrische Energie zur Verfügung steht, um auch in dunkleren Räumen, deren Helligkeit zum normalen Betrieb der Solarzelle nicht ausreichend wäre, Messungen des Stromdurchgangs durchführen zu können.

Vorzugsweise ist jenes Anzeigeelement, welches der Anzeige des an den Prüfspitzen anliegenden Spannungswertes dient, als Leuchtdiode ausgebildet. Hierdurch wird der Tatsache Rechnung getragen, daß über die Prüfspitzen eine zum Betrieb der relativ energieintensiven Leuchtdiode ausreichende Spannung zur Verfügung steht.

Schließlich wird eine an einem der Handgriffe angeordnete, beim Benutzen des Prüfgerätes durch die Hand des Benutzers berührte Elektrode vorgeschlagen, welche der Schließung eines Meßkreises für einpolige Phasenprüfungen dient. Hierdurch läßt sich der Einsatzbereich des Prüfgerätes zusätzlich noch auf die Durchführung einpoliger Phasenprüfungen erweitern.

Weitere Vorteile und Einzelheiten der Erfindung ergeben sich aus der nachfolgenden Beschreibung eines auf der Zeichnung dargestellten Ausführungsbeispieles. In der Zeichnung zeigen:
- Fig. 1: In einer Ansicht ein aus zwei mit Prüfspitzen versehenen Handgriffen zusammengesetztes Prüfgerät zum wahlweisen Erfassen einer elektrischen Spannung oder zum Messen des Stromdurchgangs durch einen elektrischen Leiter und
- Fig. 2: einen Schaltplan des Prüfgerätes nach Fig. 1.

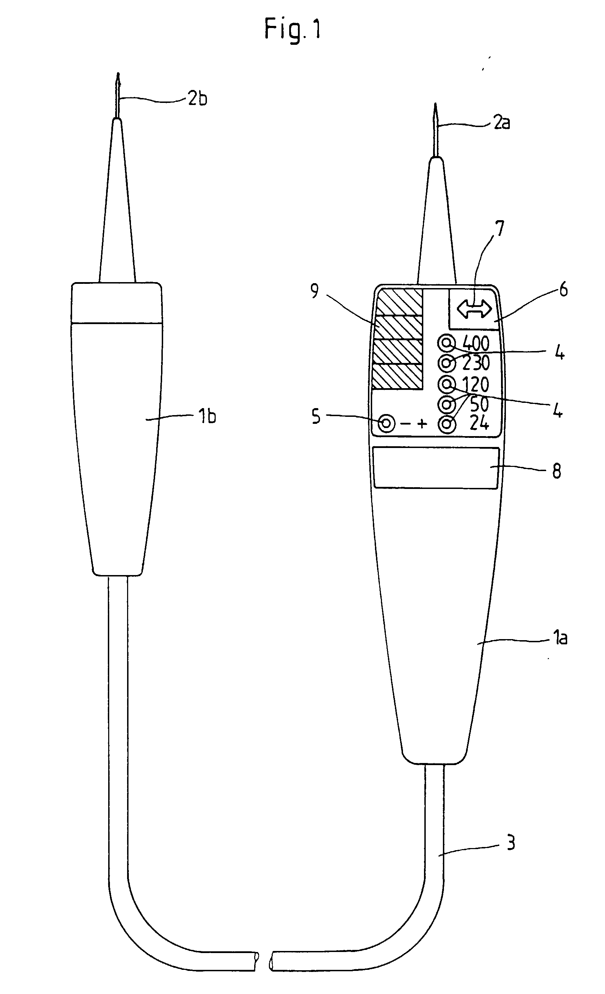

Das in Fig. 1 dargestellte Prüfgerät dient dem wahlweisen Anzeigen einer elektrischen Spannung oder des Stromdurchgangs durch einen elektrischen Leiter. Es verfügt über eine im wesentlichen aus einer von einem ersten Spritzgußgehäuse 1a ummantelten ersten Prüfspitze 2a und einer über ein Kabel 3 verbundenen, von einem zweiten Spritzgußgehäuse 1b ummantelten zweiten Prüfspitze 2b.

Während das Spritzgußgehäuse 1b der zweiten Prüfspitze 2b ausschließlich dazu dient, von Hand eine Verbindung zu den zu prüfenden elektrischen Leitungen herzustellen, ist das mit der ersten Prüfspitze 2a versehene Spritzgußgehäuse la mit verschiedenen Anzeigen und Bedienungshinweisen versehen. Insbesondere nimmt das erste Gehäuse 1a eine nachfolgend noch näher erläuterte Meßschaltung auf.

Auf der Oberseite des Gehäuses 1a sind insgesamt sechs Leuchtdioden 4,5 gut sichtbar angeordnet. Die Leuchtdioden 4 dienen der Anzeige der mittels der Prüfspitzen 2a,2b gemessenen elektrischen Spannung und sind hierzu mehrstufig geschaltet. Die Leuchtdiode 5 dient in Verbindung mit einer der Leuchtdioden 4 der Polaritätsanzeige der gemessenen Spannung.

Eine weitere Anzeige auf der Oberseite des Gehäuses la ist als LCD-Element 6 ausgebildet. Das LCD-Element 6 gibt dem Benutzer durch Anzeige eines Pfeiles 7 oder eines anderes Symboles darüber Auskunft, ob ein mit den beiden Prüfspitzen 2a,2b in Verbindung gebrachter elektrischer Leiter in dem dazwischen liegenden Abschnitt elektrisch durchgängig ist.

Ferner verfügt das Gehäuse la über ein Tastfeld 8, mit dem sich eine kapazitive Ankopplung für einpolige Phasenprüfungen durchführen läßt. Das Tastfeld 8 ist so an dem Gehäuse la angeordnet, daß es sich während des Haltens des als Handgriff ausgebildeten Gehäuse la mit dem Daumen des Benutzers berühren läßt.

Ebenfalls auf der Oberseite des Gehäuses la schließlich ist ein Panel einer Solarzelle 9 angeordnet. Die Solarzelle 9 stellt den für die Durchführung der Stromdurchgangs-Messungen erforderlichen Meßstrom zur Verfügung und versorgt außerdem das LCD-Element 6 mit der zur Anzeige erforderlichen Spannung.

Irgendwelche von dem Benutzer des Prüfgerätes zu betätigende Schalter sind an dem Prüfgerät nicht vorgesehen. Vielmehr wird die elektrische Spannung nach Größe und Polarität gemessen, sobald an den beiden Prüfspitzen 2a,2b eine entsprechende Spannung anliegt. Für Prüfungen auf Stromdurchgang werden die beiden Prüfspitzen 2a,2b an den interessierenden Leiterabschnitt gehalten und dann der durch die elektrische Energie der Solarzelle 9 erzeugte Prüfstrom an diesen Leiterabschnitt gelegt. Eine Umschaltung zwischen den beiden genannten Meßmöglichkeiten des insofern als Kombigerät ausgebildeten Prüfgerätes findet nicnt statt.

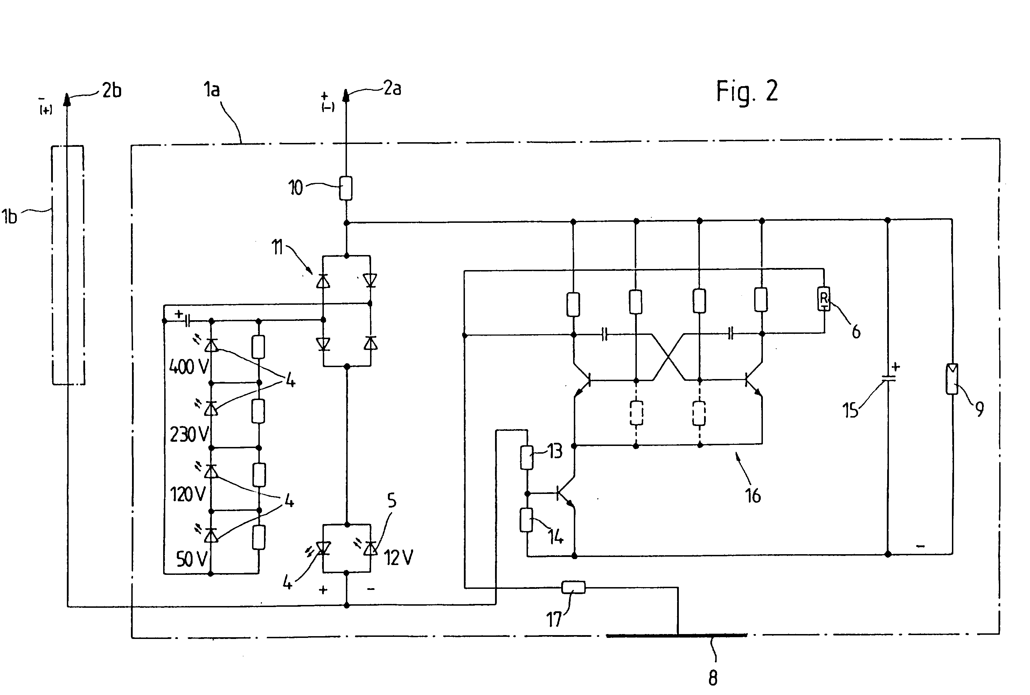

Einzelheiten der verwendeten Schaltung sind in Fig. 2 dargestellt. Die Prüfspitze 2a steht über einen Vorwiderstand 10, eine Gleichrichterschaltung 11 sowie die zwei antiparallelen Leuchtdioden 4,5 mit der weiteren Prüfspitze 2b in elektrischer Verbindung. An die Gleichrichterschaltung 11 ist ein Gleichstromkreis mit vier Spannungsstufen angekoppelt. Diese Spannungsstufen (Schwellwertstufen) bestehen jeweils aus einem Widerstand 12 mit einer parallelgeschalteten Leuchtdiode 4, wobei die Widerstände 12 in Reihe miteinander geschaltet sind.

Die Teile bzw. Elemente 4,5,10 und 11 bilden eine Meßschaltung, mit der sich die an den Prüfspitzen 2a,2b anliegende elektrische Spannung erfassen und über die Leuchtdioden 4,5 anzeigen läßt.

Parallel zu der aus den beiden antiparallelen Leuchtdioden 4,5 sowie der Gleichrichterschaltung 11 zusammengesetzten Baueinheit ist eine weitere Meßschaltung angeordnet. Diese besteht aus zwei in Reihe hintereinander geschalteten Widerständen 13,14, zu denen in Reihe die Solarzelle 9 geschaltet ist. Ebenfalls in Reihe zu den Widerständen 13,14, jedoch parallel zu der Solarzelle 9 ist ein Elektrolyt-Kondensator 15 vorgesehen. Der parallel zu der Solarzelle 9 geschaltete Elektrolyt-Kondensator 15 wird bei normalem Lichteinfall durch die Solarzelle 9 aufgeladen und kann anschließend seine elektrische Energie auch im Fall ungenügender Tätigkeit der Solarzelle 9 abgeben.

Bestandteil der Meßschaltung für den Stromdurchgang ist ferner das LCD-Element 6 sowie eine Steuerschaltung 16 hierfür. Die Steuerschaltung 16 ist parallel an den Elektrolyt-Kondensator 13 angeknüpft, so daß für den Fall, daß die beiden Prüfspitzen 2a,2b an einen durchgängigen Leiter angelegt werden, die durch die Solarzelle 9 erzeugte bzw. vom Elektrolyt-Kondensator 15 gespeicherte elektrische Energie zu einer geringen Spannung am LCD-Element 6 führt, so daß dieses einen Stromdurchgang signalisiert. Eine Batterie oder andere Spannungsquellen zur Erzeugung des für die Durchgangsprüfung erforderlichen Prüfstromes sind daher nicht erforderlich.

Zur Durchführung einpoliger Phasenprüfungen ist das auf der Außenseite des Gehäuses 1a befindliche, nach Art einer Elektrode ausgebildete Tastenfeld 8 über einen Zwischenwiderstand 17 an die Meßschaltung angeknüpft. Hierdurch wird eine kapazitive Ankopplung zum Zwecke der Phasenprüfung erreicht.

### Bezugszeichenliste

- 1a: Gehäuse
- 1b: Gehäuse
- 2a: Prüfspitze
- 2b: Prüfspitze
- 3: Kabel
- 4: Leuchtdioden
- 5: Leuchtdiode
- 6: LCD-Element
- 7: Pfeil
- 8: Tastfeld
- 9: Solarzelle
- 10: Vorwiderstand
- 11: Gleichrichterschaltung
- 12: Widerstand
- 13: Widerstand
- 14: Widerstand
- 15: Elektrolyt-Kondensator
- 16: Steuerschaltung
- 17: Zwischenwiderstand

## Patentansprüche

1. Prüfgerät zum wahlweisen Anzeigen einer elektrischen Spannung oder des Stromdurchgangs durch einen elektrischen Leiter mit zwei über ein Kabel (3) miteinander verbundenen, jeweils mit einer Prüfspitze (2a, 2b) versehenen Handgriffen (1a, 1b), mit einer Meßschaltung sowie mindestens einem Anzeigeelement (4, 5) zur Erfassung und Anzeige des an den Prüfspitzen (2a, 2b) anliegenden Spannungswertes sowie mit einer Spannungsquelle zur Bereitstellung des für die Messung und Anzeige des Stromdurchgangs erforderlichen Stromes,
**dadurch gekennzeichnet,**
daß die Spannungsquelle als Solarzelle (9) ausgebildet ist, welcher ein Elektrolyt-Kondensator (15) und eine Steuerschaltung (16) für ein den Stromdurchgang anzeigendes LCD-Element (6) parallelgeschaltet ist.

2. Prüfgerät nach Anspruch 1, dadurch gekennzeichnet, daß das Anzeigeelement (4, 5) zur Anzeige des an den Prüfspitzen (2a, 2b) anliegenden Spannungswertes als Leuchtdiode ausgebildet ist.

3. Prüfgerät nach einem der Ansprüche 1 oder 2, gekennzeichnet durch eine an einem der Handgriffe (1a, 1b) angeordnete, beim Benutzen des Prüfgerätes durch die Hand des Benutzers berührte Elektrode (8) zur Schließung eines Meßkreises für einpolige Phasenprüfungen.

## Claims

1. Test set for optional indication of an electrical voltage or the current passing through an electrical conductor, having two handles (1a, 1b) which are connected to one another via a cable (3) and are each provided with a test probe (2a, 2b), having a measurement circuit and having at least one display element (4, 5) for detecting and indicating the voltage value applied to the test probes (2a, 2b), and having a voltage source for providing the current required for measurement and for indicating the current passing, characterized in that the voltage source is configured as a solar cell (9) which is connected in parallel with an electrolytic capacitor (15) and a control circuit (16) for an LCD element (6) which indicates the current passing.

2. Test set according to Claim 1, characterized in that the display element (4, 5) for indicating the voltage value applied to the test probes (2a, 2b) is configured as a light-emitting diode.

3. Test set according to one of Claims 1 or 2, characterized by an electrode (8) which is arranged on one of the handles (1a, 1b) and is touched by the hand of the user when the test set is in use, in order to close a test circuit for single-pole phase tests.

## Revendications

1. Appareil de test pour indiquer au choix une tension électrique ou le passage de courant dans un conducteur électrique, cet appareil de test comportant deux poignées (1a, 1b), reliées par un câble (3) et munies chacune d'une pointe de test (2a, 2b), un circuit de mesure et au moins un élément indicateur (4, 5) pour détecter et indiquer la valeur de tension présente aux pointes de test (2a, 2b) et une source de tension pour fournir le courant nécessaire à la mesure et à l'indication du passage de courant, caractérisé en ce que la source de tension est conçue sous forme de cellule solaire (9) en parallèle de laquelle sont branchés un condensateur électro-chimique (15) et un circuit de commande (16) pour un élément LCD (6) indiquant le passage de courant.

2. Appareil de test selon la revendication 1, caractérisé en ce que l'élément indicateur (4, 5) destiné à indiquer la valeur de tension présente aux pointes de test (2a, 2b) est conçu sous forme de diode luminescente.

3. Appareil de test selon l'une des revendications 1 ou 2, caractérisé par une électrode (8) agencée sur une des poignées (1a, 1b), touchée par la main de l'utilisateur lors de l'utilisation de l'appareil de test et destinée à fermer un circuit de mesure pour des tests de phases unipolaires.
